(19)

Europäisches
Patentamt
European
Patent Office
Office européen
des brevets

(11) **EP 3 604 478 A1**

(12) **EUROPEAN PATENT APPLICATION**

(43) Date of publication:
**05.02.2020 Bulletin 2020/06**

(51) Int Cl.:
***C09K 11/77*** *(2006.01)*          ***H01L 33/50*** *(2010.01)*

(21) Application number: **18382592.6**

(22) Date of filing: **03.08.2018**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Consejo Superior de Investigaciones
Científicas
(CSIC)
41013 Sevilla (ES)**

(72) Inventors:
• **GENG, Dongling**
 **41092 Sevilla (ES)**
• **LOZANO, Gabriel**
 **41092 Sevilla (ES)**
• **MÍGUEZ, Hernán**
 **41092 Sevilla (ES)**

(74) Representative: **Pons
Glorieta Ruben Dario 4
28010 Madrid (ES)**

(54) **EFFICIENT TRANSPARENT WHITE LIGHT EMITTING LAYERED PHOSPHOR STRUCTURE OF TUNABLE SHADE, PROCESS FOR OBTAINING SAID STRUCTURE AND USES**

(57)     The present invention discloses a novel transparent, efficient and tuneable white light emitting phosphor structure based on thin sintered nanophosphor layers. Furthermore, the present invention refers to the process for obtaining said the transparent layered phosphor structure by means of dip coating technique and thermal annealing. Moreover, the present invention refers to the uses of said phosphor structure for the emission of white color of tunable chromaticity, as part of a device.

EP 3 604 478 A1

## Description

The present invention discloses a novel transparent, efficient and tuneable white light emitting phosphor structure based on thin sintered nanophosphor layers. Furthermore, the present invention refers to the process of obtaining said transparent layered phosphor structure by means of wet deposition techniques, herein dip coating process was used, and thermal annealing. Moreover, the present invention refers to the uses of said phosphor structure for the emission of white color of tunable chromaticity, as part of a device.

## BACKGROUND ART

Fluorescent coatings based on lanthanide cation doped phosphors are key ingredients in nowadays light-emitting devices [Z. Xia, Q. Liu, Progress in Materials Science, 2016, 84, 59]. Their robustness lies in the high chemical and thermal stability of their optical performance, which make them almost insensitive to temperature or environmental changes. The canonical configuration found in most luminaries of this kind consist of an electroluminescent blue light-emitting diode (LED) used to photo-excite a thick coating of cerium doped yttrium aluminium garnet (Ce-YAG) crystals, which emits broadband in the green-to-red region of the visible spectrum [Ye S, Xiao F, Pan YX, Ma Y Y, Zhang Q Y, Mater. Sci. Eng. Rep., 2010, 71, 1]. The combination of such photoluminescence with the part of the incoming blue light that passes through the colour converter without being absorbed results in the white light we are accustomed to.

This highly successful approach has, however, certain drawbacks. One of them is that it is hard to tune the chromaticity of the white emission; the other is that it cannot be employed to obtain transparent photoluminescent displays. The reason is the strong diffuse scattering that occurs inside the colour converting layer, which is a disordered packing of large irregular phosphor crystals (several micrometres of average size). The limitations imposed by this lack of transparency have motivated the search for ways to obtain optical quality Ce-YAG [S. Murai, M.A. Verschuuren, G. Lozano, G. Pirruccio, A.F. Koenderink, J. Gomez Rivas, Opt. Mater. Ex., 2012, 2, 1111 *and* S. Murai, T. Sato, S. Yao, R. Kamakura, K. Fujita, K. Tanaka, J. Luminescence, 2016, 170, 808], Murai et al. have actually shown that it is possible to synthesize this material in the form of thin films with optical quality. However, the low extinction coefficient at short visible wavelengths hinders the consecution of a balanced white with thin films. Also, a wide variety of matrices have been doped with one or several kinds of rare earth cations, including glass-ceramics, metal organic frameworks, layered hydroxides, etc., with the aim of achieving transparency and white emission simultaneously, but low efficiency is achieved in most cases [A. Santana-Alonso, J. Mendez-Ramos, A.C. Yanes, J. del-Castillo, V.D. Rodriguez, Mater. Chem. Phys., 2010, 124, 699*; D. Chen, W. Xiangb, X. Liang, J. Zhong, H. Yu, M. Ding, H. Lu, Z. Ji, J. Eur. Ceram. Soc., 2015, 35, 859; L. Liu, M. Yu, J. Zhang, B. Wang, W. Liua, Y. Tang, J. Mater. Chem. C, 2015, 3, 2326; S. Zhou, N. Jiang, B. Zhu, H. Yang, S. Ye, G. Lakshminarayana, J. Hao, J. Qiu, Adv. Funct. Mater., 2008, 18, 1407; T. Shen, Y Zhang, W. Liu, Y. Tang, J. Mater. Chem. C, 2015, 3, 1807; K.-H. Lee, B.-I. Lee, J.-H. You, S.-H. Byeon, Chem. Commun., 2010, 46, 1461; L. V. Meyer, F. Schönfeld, K.Müller-Buschbaum, Chem. Commun., 2014, 50, 8093].

For the reasons stated above, it is needed to develop new efficient transparent white emitting materials of tunable shade.

## SUMMARY OF THE INVENTION

The present invention discloses a novel transparent, efficient and tuneable white light emitting phosphor structure based on thin sintered nanophosphor layers. Absence of light scattering in the structure provides both transparency and efficient photoexcitation of inner nanophosphor layers.

Furthermore, the present invention refers to the process of obtaining said transparent layered phosphor structure by means of dip coating technique and thermal annealing. Moreover, the present invention refers to the uses of said phosphor structure for the emission of white color of tunable chromaticity, as part of a device.

The thickness of the constituent nanophosphor layers is key for achieving total extinction of the incoming photoexcitation as well as bright white light emission of tuneable shade.

A variety of white colour shades can be devised simply by modifying the relative thickness of each nanophosphor layer, without altering the chemical composition of the emitters.

Furthermore, the shade of the white emission from a given coating can be continuously tuned by means of the gradual shift of the photoexcitation wavelength, a consequence of the spectral dependence of the light penetration depth.

Total extinction of incoming radiation along with Quantum Yields above 35% make these layered phosphors one of the most efficient transparent white converter coatings developed up to date.

Hence, a first aspect of the present invention relates to a transparent layered phosphor structure. Said term refers herein to a multilayered structure comprising a bilayer of doped nanophosphors which provide both transparency and efficient white colour emission. The transparent layered phosphor structure of the present invention is characterized in that it comprises the following elements:

- a transparent substrate;
- a first layer of $ZrO_2$ located onto the top of the substrate and having a thickness of between 50 nm and 100 nm;

- a second layer of $GdVO_4:Eu^{3+}$- doped phosphor nanocrystals emitting lines in the red 615 nm, located onto the top of the first layer, having a thickness of between 100 nm and 300 nm; and
- a third layer of $GdVO_4:Dy^{3+}$-doped nanophosphor emitting lines in the blue 483 nm and in the yellow 572 nm, located onto the second layer, having a thickness of between 100 nm and 300 nm;

wherein the second and the third layers sum a thickness of between 200 nm and 600 nm.

$GdVO_4:Dy^{3+}$ and $GdVO_4:Eu^{3+}$ doped phosphor nanocrystals are used as building blocks of a white light-emitting phosphor bilayer. $Dy^{3+}$ and $Eu^{3+}$ are selected as activators because they feature narrow emission lines in the blue (483 nm) and yellow (572 nm) part of the visible, and in the red (615 nm), respectively. Furthermore, the vanadate-based matrix ($VO_4^{3-}$) allows the effective photoexcitation of the rare-earth (RE) cations, i.e. $VO_4^{3-}$ transfer energy efficiently to both $Dy^{3+}$ and $Eu^{3+}$.

An aim of the $ZrO_2$ layers is to improve adhesion of the phosphor bilayer to the substrate. The substrate of the structure of the present invention is made of a UV transparent material such as quartz. The term UV transparent substrate/material refers herein to a substrate/material which is transparent to UV light ranging from 280 nm and 400 nm. In a preferred embodiment, the transparent layered phosphor structure further comprises a fourth layer of $ZrO_2$, located onto the top of the third layer, having a thickness of between 50 nm and 100 nm.

The order of the layers and the thickness of the phosphor bilayer are important features for achieving the desired transparency and efficient bright white light emission of tunable shade.

A further aspect of the present invention relates to a process of obtaining the transparent layered phosphor structure mentioned before (herein "the process of the invention") which comprises the following steps:

a) sequential deposition by means of dip coating technique of the following layers:

- a first layer of $ZrO_2$ nanocrystals located onto the top of a transparent substrate and having a thickness of between 50 nm and 100 nm;
- a second layer of $GdVO_4:Eu^{3+}$ phosphor nanocrystals onto the top of the first layer and having a thickness of between 100 nm and 300 nm;
- a third layer of $GdVO_4:Dy^{3+}$ onto the second layer having a thickness of between 100 nm and 300 nm, and
- optionally, a fourth layer of $ZrO_2$ onto the top of the third layer having a thickness of between 50 nm and 100 nm;

and b) thermal annealing of the transparent layered phosphor structure obtained in step (a) at a temperature between 500 °C and 800 °C.

In a preferred embodiment of the process of the invention, it comprises the following steps:

a) sequential deposition by means of dip coating technique of the following layers:

- a first layer of $ZrO_2$ nanocrystals located onto the top of a transparent substrate and having a thickness of between 50 nm and 100 nm;
- a second layer of $GdVO_4:Eu^{3+}$ phosphor nanocrystals onto the top of the first layer and having a thickness of between 100 nm and 300 nm;
- a third layer of $GdVO_4:Dy^{3+}$ onto the second layer having a thickness of between 100 nm and 300 nm, and
- a fourth layer of $ZrO_2$ onto the top of the third layer having a thickness of between 50 nm and 100 nm;

and b) thermal annealing of the transparent layered phosphor structure obtained in step (a) at a temperature between 500°C and 800 °C.

Transparency is preserved all through the process of the invention.

Step (a) of the process of the invention refers to the sequential deposition of the layers forming the transparent layered phosphor structure of the invention by means of dip coating technique. As mentioned before, the order of the layers is important therefore deposition has to be performed sequentially. In order to achieve white light emission, the second and the third layers sum a thickness of between 200 nm and 600 nm. Full extinction of the photoexcitation is guaranteed in this way.

Step (b) of the process of the invention refers to the thermal annealing of the transparent layered phosphor structure obtained in step (a) at a temperature between 500°C and 800 °C.

Thermal annealing gives rise to porous but continuous films in which structural defects and surface traps present in the prepared $GdVO_4:Dy^{3+}$ and $GdVO_4:Eu^{3+}$ doped phosphor nanocrystals are reduced. Furthermore, each layer of the phosphor bilayer responds equally to the thermal annealing being the interface between the two types of RE doped layers indistinguishable.

The last aspect of the present invention refers to the use of the transparent layered phosphor structure mentioned above for the emission of white color of tunable chromaticity with photoexcitation wavelength ranging between 280 nm and 320 nm. It is to mention that the transparent layered phosphor structure can be a coating made of bilayer stack of $GdVO_4:Dy^{3+}$ and $GdVO_4:Eu^{3+}$ nanoparticles.

A preferred embodiment of the use of the transparent layered phosphor structure refers to the use of the phosphor structure as part of a device for the emission of white light of tunable chromaticity, which comprises a LED emitting light providing a photo-excitation wavelength ranging between 280 nm and 320 nm.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

**BRIEF DESCRIPTION OF THE DRAWINGS**

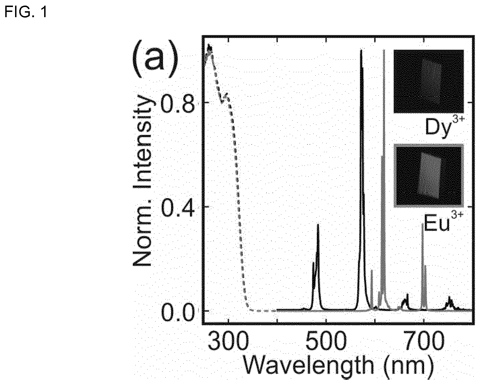

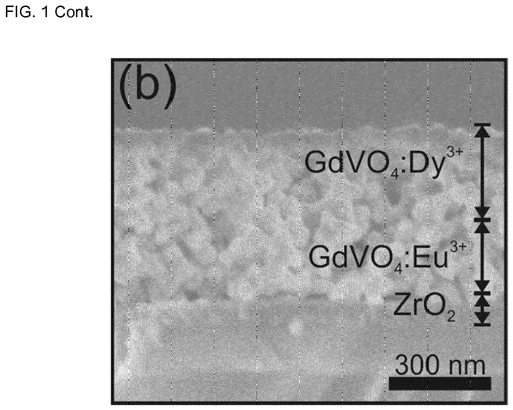

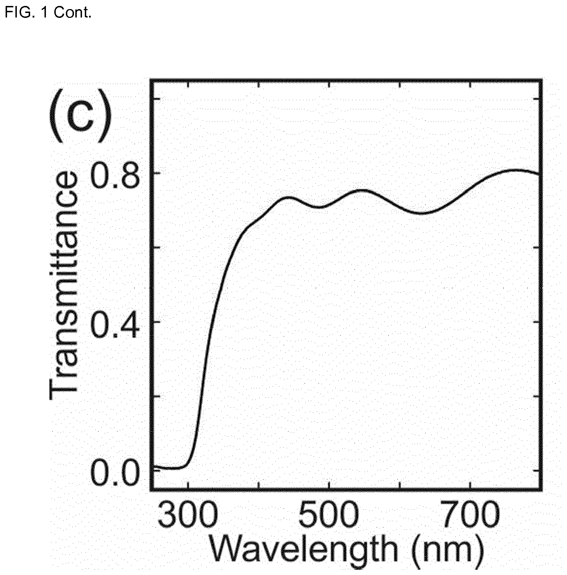

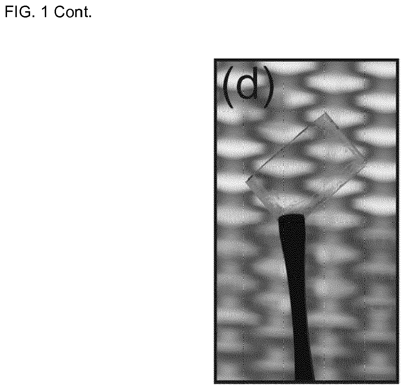

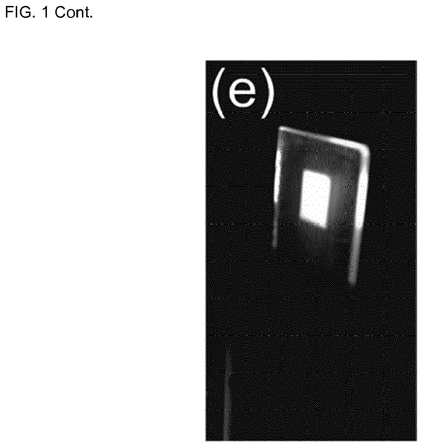

Fig. 1 Normalized photoluminescence spectra of $GdVO_4:Dy^{3+}$ (solid black line) and $GdVO_4:Eu^{3+}$ films (solid grey line) when illuminated at 295 nm; photoexcitation spectra attained while detecting at 572 nm (dashed black line) or 615 nm (dashed grey line). Pictures of the emission color of films illuminated at 295 nm are shown as insets. (b) FESEM image of a cross section of the layered phosphor coating made by the sequential deposition of $GdVO_4:Dy^{3+}$ and $GdVO_4:Eu^{3+}$ nanophosphor layers followed by sintering. (c) Ballistic transmittance spectrum of the layered phosphor coating. (d-e) Photographs of the same film under natural and UV light, respectively.

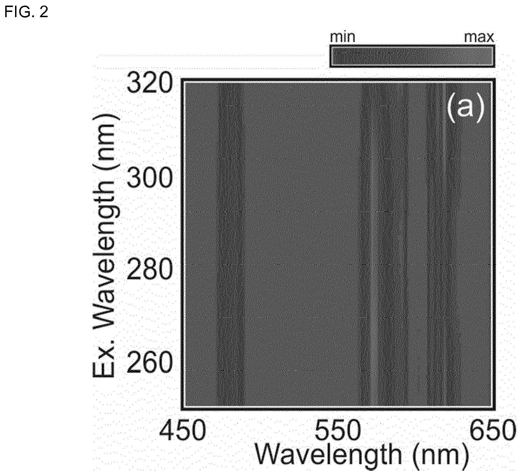

FIG. 2 (a) Photoluminescence spectra attained from a layered phosphor stack when photoexcitation wavelength is gradually varied between 250 nm and 320 nm. All curves are normalized to the maximum intensity attained at 572 nm when the stack is illuminated at 265 nm. (b) Photoluminescence spectrum of the stack illuminated at 275 nm (black) and 300 nm (grey). Grey curve has been vertically shifted for the sake of clarity. (c) Time dependence photoluminescence of $^4F_{9/2}$ and $^5D_0$ levels of $Dy^{3+}$ (circles) and $Eu^{3+}$ activators (squares) in the stack, respectively, together with their corresponding fit to a sum of two log-normal distributions of decay rates (black solid lines). Time dependence of the same transitions when the activators are deposited as isolated films is also shown as dark and light grey symbols, respectively. (d) Photoluminescence quantum yield versus the photoexcitation wavelength for a $GdVO_4:Dy^{3+}$ layer (circles), a $GdVO_4:Eu^{3+}$ layer (squares), and a $GdVO_4:Dy^{3+}/GdVO_4:Eu^{3+}$ stack

(triangles).

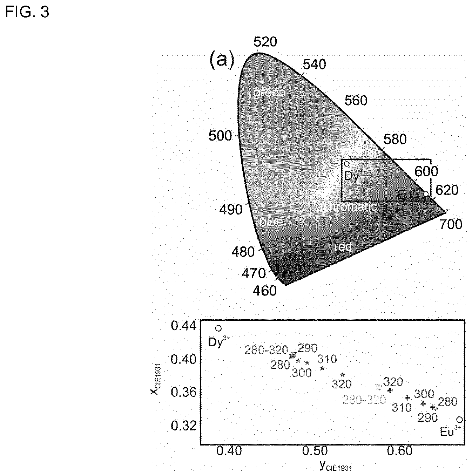

FIG. 3 (a) CIE 1931 chromaticity coordinates of the light emitted by a $GdVO_4:Dy^{3+}$-$GdVO_4:Eu^{3+}$ stack (stars) and a $GdVO_4:Eu^{3+}$-$GdVO_4:Dy^{3+}$ stack bilayer (crosses) as a function of the photoexcitation wavelength. Color coordinates of a mixture $GdVO_4:Dy^{3+}/GdVO_4:Eu^{3+}$ with 85% (dark grey squares) and 60% of $Dy^{3+}$ (light grey squares) along with the coordinates of $GdVO_4:Dy^{3+}$ and $GdVO_4:Eu^{3+}$ layers (open circles) are also shown. (b-e) Digital pictures of the photoemission of a $GdVO_4:Dy^{3+}$-$GdVO_4:Eu^{3+}$ bilayer phosphor for four different photoexcitation wavelengths: i.e. 280 nm (b), 290 nm (c), 300 nm (d) and 310 nm (e).

**EXAMPLES**

**Example 1**

Herein we present a synthetic route to prepare transparent, efficient and tunable white light emitting phosphor coatings based on the stack of thin sintered nanophosphor films. The thickness of the constituent layers has been optimized to achieve total extinction of the incoming photoexcitation as well as bright white light emission of tunable shade. Absence of light scattering in the stack provides both transparency and efficient photoexcitation of inner layers. The shade of the emission light from a given coating can be continuously tuned without altering the chemical composition of the emitters by means of the gradual shift of the photoexcitation wavelength, a consequence of the spectral dependence of the light penetration depth. Total extinction of incoming radiation along with Quantum Yields (QYs) above 35% make these layered phosphors one of the most efficient transparent white converter coatings ever developed.

Layered phosphor structures were fabricated by sequential dip coating of nanophosphor films. In order to improve adhesion to the substrate (quartz), the phosphor bilayer is deposited over a thin layer of $ZrO_2$.

We employed $GdVO_4:Dy^{3+}$ and $GdVO_4:Eu^{3+}$ phosphor nanocrystals as building blocks to obtain a white light-emitting bilayer. We choose $Dy^{3+}$ and $Eu^{3+}$ activators because they feature narrow emission lines in the blue (483 nm) and yellow (572 nm) part of the visible, and in the red (615 nm), respectively, as shown in **FIG. 1(a)**. Besides, the choice of host allows an effective photoexcitation of the rare-earth (RE) cations through the vanadate-based matrix, since $VO_4^{3-}$ transfer energy efficiently to both $Dy^{3+}$ and $Eu^{3+}$. In order to achieve white light emission, stacks with a total thickness of ~500 nm were prepared so that full extinction of the photoexcitation was guaranteed.

Eventually, layered coatings were sintered at 800°C. Thermal annealing gives rise to porous but continuous films in which structural defects and surface traps present in as-prepared nanocrystals are reduced.

A field emission scanning electron microscopy (FESEM) image of the cross section of one of these stacks is shown in **FIG. 1(b)**. Since the crystalline matrix hosting the two types of cations employed is the same, each layer in the stack responds equally to the thermal treatment, being the interface between the two types of RE doped layers indistinguishable.

A Cary 7000 series UV-Vis-NIR spectrophotometer is used to determine absolute values of the ballistic transmittance. Illustrative results attained for a bilayer stack composed of ~300 nm of $GdVO_4$:$Dy^{3+}$ and ~200 nm of $GdVO_4$:$Eu^{3+}$ are shown in **FIG. 1(c)**. Transmittance remains above 70% for the complete visible range, with oscillations that arise as a result of the optical interference occurring in the layered stack. The fraction of light absorbed by the bilayer reaches 70% in the UV, range at which the phosphors of choice are excited, being the remaining light at those short wavelengths diffusely scattered by the disordered pore network present in the sintered films. So, although the random porous network observable in the bulk of the film does not give rise to diffuse visible light, it scatters shorter wavelength photons to some non-negligible extent.

The transparency ($\tau$) of the stacks, can be formally estimated with the expression (*ISO 9050:2003*):

$$\tau = \frac{\int_{\lambda_1}^{\lambda_2} T(\lambda) F(\lambda) P(\lambda) d\lambda}{\int_{\lambda_1}^{\lambda_2} F(\lambda) P(\lambda) d\lambda}$$

(1)

where $P(\lambda)$ is the photopic spectral luminous efficiency function, which represents the sensitivity of an observer in photometry (*ISO/CIE 10527*), and F is the AM1.5 solar spectral irradiance. Values of $\tau$ for all coatings were basically the same and around 75%.

Pictures displayed in **FIG. 1(d)** and **FIG. 1(e)**, confirm that the resulting films are highly transparent and emit white light when illuminated with the adequate UV light. Notice that UV LEDs in combination with phosphor mixtures typically provide sources with higher color rendering index, which could potentially minimize light pollution.

The photophysical properties of the coatings were studied by means of photoexcitation and PL spectroscopy using a spectrofluorometer (Edinburgh FLS1000). Excitation wavelength ($\lambda_{ex}$) was varied from 250 nm to 320 nm. Results for a particular configuration, namely a bilayer stack composed of -300 nm of $GdVO_4$:$Dy^{3+}$ and -200 nm of $GdVO_4$:$Eu^{3+}$ are shown in **FIG. 2(a)**.

Interestingly, the photoemission spectra are extremely dependent on the excitation wavelength. This is a direct consequence of the layered structure of the coating. In the selected example, light encounters first the $GdVO_4$:$Dy^{3+}$ layer and then the $GdVO_4$:$Eu^{3+}$ one. The shorter the excitation wavelength, the smaller the penetration depth in the stack.

So, for 250 nm $\leq \lambda_{ex} \leq$ 290 nm, all incoming intensity is practically absorbed by the $GdVO_4$:$Dy^{3+}$ layer and hardly reaches the second $GdVO_4$:$Eu^{3+}$ layer. Hence the features of $Dy^{3+}$ dominate over those of $Eu^{3+}$ in the photoemission spectrum.

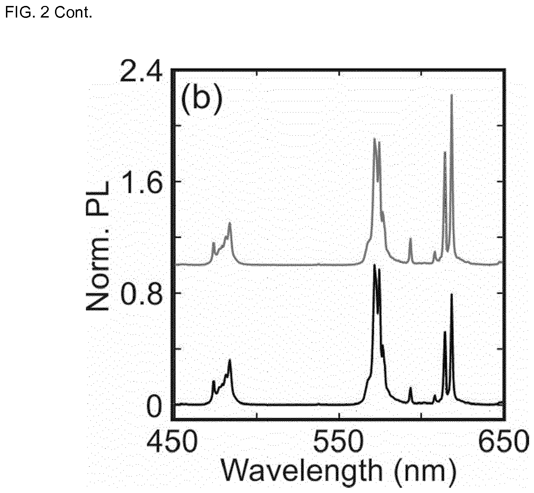

As the photo-excitation wavelength increases, the penetration depth in the stack also increases and the balance between the contributions from both species improves, as it can be seen for those spectra attained when photo-exciting with 295 nm $\leq \lambda_{ex} \leq$ 320 nm. This is further illustrated in **FIG. 2(b)**, in which the photoemission spectra attained when illuminating the same bilayer at either $\lambda_{ex}$=275 nm (black) or $\lambda_{ex}$=300 nm (grey) are plotted. Although both emissions lie in the achromatic region of the chromaticity space, their spectral composition is very different. Remarkably, the tuning of the emission shade is not achieved at the expense of a significant reduction of the amount of emitted light. Indeed, although the extinction coefficient of the phosphor reduces a 60% from $\lambda_{ex}$=265 nm to $\lambda_{ex}$=320 nm, the total emitted light only diminishes 15% when photo-exciting at $\lambda_{ex}$=320 nm.

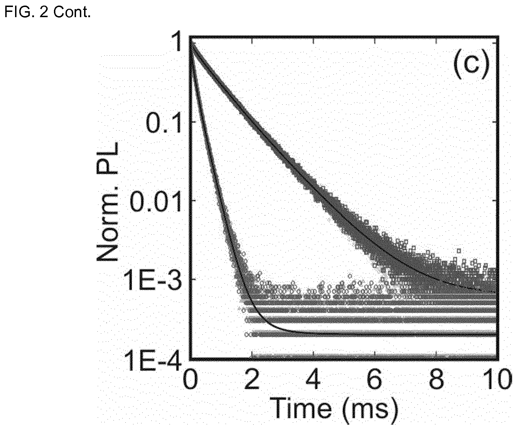

**FIG. 2(c)** shows the time-dependent PL of the $^4F_{9/2}$ level of $Dy^{3+}$ and the $^5D_0$ of $Eu^{3+}$ activators when they are forming an isolated film and when such films are stacked in a bilayer. Our results indicate that the structuring of the phosphors does not alter their dynamics, since the fitting of the decay curves yields average lifetimes of 0.22 ms and 0.94 ms for $Dy^{3+}$ and $Eu^{3+}$, respectively.

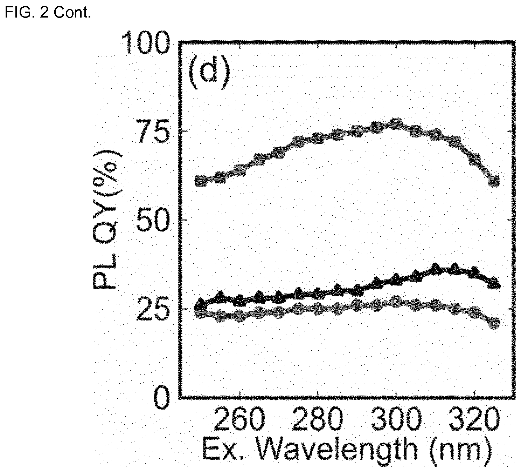

The quantum yield of the $Dy^{3+}$ layer is -25%, whereas the $Eu^{3+}$ film features an efficiency of -75%, which gives rise to QYs above 35% for the stack as shown in **FIG. 2 (d)**. Additionally, QYs of all nanophosphor films are photoexcitation wavelength dependent, which may originate from a spectral dependence of the efficiency of the charge ($Dy^{3+}$/$Eu^{3+}$-$O^{2-}$) and energy transfer ($VO_4^{3-}$-$Dy^{3+}$/$Eu^{3+}$).

The particular photochromic effect herein displayed offers a unique and unprecedented way to control the shade of the emission color attained from a phosphor coating. In this regard, the potential of these transparent stacks is analyzed by studying the photoemission of the $GdVO_4$:$Dy^{3+}$/$GdVO_4$:$Eu^{3+}$ stack in comparison with a 500 nm film in which $GdVO_4$:$Dy^{3+}$ and $GdVO_4$:$Eu^{3+}$ phosphor nanoparticles where mixed together at two different ratios. A gradual shift of the excitation energy allows attaining different chromaticity values comprised between the one of $GdVO_4$:$Dy^{3+}$ and $GdVO_4$:$Eu^{3+}$. As it can be seen in the CIE 1931 color space plotted in **FIG. 3(a)**, a variety of shades contained in the achromatic region are achieved. In particular, the photoexcitation at 300 nm yields warm white light, meeting the Planckian locus at 2600 K. In contrast, when $GdVO_4$:$Dy^{3+}$ and $GdVO_4$:$Eu^{3+}$ phosphor nanoparticles are mixed together in a film, the chromaticity of the emission is only determined by the ratio of each material in the mix, e.g. 85% of $GdVO_4$:$Dy^{3+}$ or 60% of $GdVO_4$:$Dy^{3+}$ nanophosphors, being the color coordinates of the homogeneous mixture independent of the photoexcitation wavelength as shown in **FIG. 3 (a)**. This highlights the importance of the structuring of the phosphor in order to achieve a fine control of the emission color. The thickness of each layer in the stack provides an extra parameter to control the photoexcitation wavelength at which a particular chromaticity is attained.

When the order of the layers in the stack is reversed, although the color of the emission can be also controlled with the photoexcitation wavelength, the resulting emission colors are mostly lying in the red part of the chromaticity space as it can be observed in **FIG. 3(a)**, which reveals the central role played by the specific ordering of the layers in the stack.

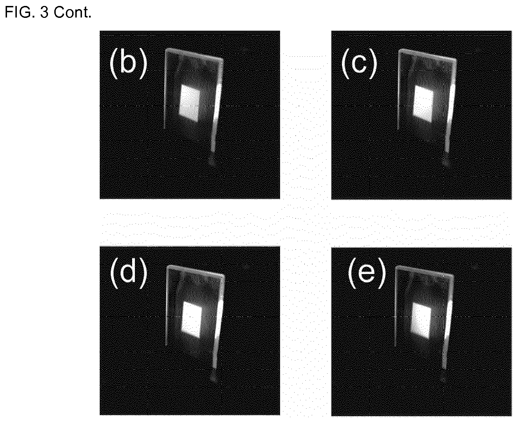

Finally, **FIG. 3 (b-e)** display digital pictures of the light emitted by the coatings, which highlight the precision in determining the coating response that can be achieved by combining the adequate bilayer configuration and excitation wavelength.

**Claims**

1.  A transparent layered phosphor structure **characterized in that** it comprises the following elements:

    • a transparent substrate;
    • a first layer of $ZrO_2$ located onto the top of the substrate and having a thickness of between 50 nm and 100 nm;
    • a second layer of $GdVO_4$:$Eu^{3+}$- doped nanophosphor emitting lines in the red 615 nm, located onto the top of the first layer, having a thickness of between 100 nm and 300 nm; and
    • a third layer of $GdVO_4$:$Dy^{3+}$-doped nanophosphor emitting lines in the blue 483 nm and in the yellow 572 nm, located onto the second layer, having a thickness of between 100 nm and 300 nm;

    wherein the second and the third layers sum a thickness of between 200 nm and 600 nm.

2.  The transparent layered phosphor structure according to claim 1, wherein the transparent substrate is made of a UV transparent material.

3.  The transparent layered phosphor structure according to any of claims 1 or 2, which further comprises a fourth layer of $ZrO_2$, located onto the top of the third layer, having a thickness of between 50 nm and 100 nm.

4.  A process of obtaining the transparent layered phosphor structure according to any of claims 1 to 3, **char-**acterized in that it comprises the following steps:

    a) sequential deposition by means of dip coating technique of the following layers:

    • a first layer of $ZrO_2$ nanocrystals located onto the top of a transparent substrate and having a thickness of between 50 nm and 100 nm;
    • a second layer of $GdVO_4$:$Eu^{3+}$ phosphor nanocrystals onto the top of the first layer and having a thickness of between 100 nm and 300 nm;
    • a third layer of $GdVO_4$:$Dy^{3+}$ onto the second layer having a thickness of between 100 nm and 300 nm, and
    • optionally, a fourth layer of $ZrO_2$ onto the top of the third layer having a thickness of between 50 nm and 100 nm;

    and b) thermal annealing of the transparent layered phosphor structure obtained in step (a) at a temperature between 500 °C and 800 °C.

5.  Use of the transparent layered phosphor structure according to claims 1 to 3 for the emission of white color of tunable chromaticity with photoexcitation wavelength ranging between 280 nm and 320 nm.

6.  Use according to claim 4, as part of a device for the emission of white light of tunable chromaticity which comprises a LED emitting light providing a photoexcitation wavelength of between 280 nm and 320 nm.

FIG. 1

FIG. 1 Cont.

FIG. 1 Cont.

FIG. 1 Cont.

FIG. 1 Cont.

FIG. 2

FIG. 2 Cont.

FIG. 2 Cont.

FIG. 2 Cont.

FIG. 3

FIG. 3 Cont.

Europäisches
Patentamt

European
Patent Office

Office européen
des brevets

# EUROPEAN SEARCH REPORT

**Application Number**

EP 18 38 2592

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2007/108888 A1 (CHEN WEI-KUO [TW] ET AL) 17 May 2007 (2007-05-17) * claims 1-89; figure 1 * | 1-6 | INV. C09K11/77 H01L33/50 |
| A | US 2010/059771 A1 (LOWERY CHRIS [US] ET AL) 11 March 2010 (2010-03-11) * claims 1-20 * | 1-6 | |
| A | US 2010/207139 A1 (WINKLER HOLGER [DE] ET AL) 19 August 2010 (2010-08-19) * paragraph [0052] * | 1-6 | |
| A | US 2006/063155 A1 (KOHLER BURKHARD [DE] ET AL) 23 March 2006 (2006-03-23) * paragraph [0036]; claims 1,3 * | 1-6 | |
| A | US 3 999 145 A (GILMAN JOHN J ET AL) 21 December 1976 (1976-12-21) * claims 1-9 * | 1-6 | |
| A | US 3 690 929 A (YOKOTA YOSHIYUKI ET AL) 12 September 1972 (1972-09-12) * example 14 * | 1-6 | TECHNICAL FIELDS SEARCHED (IPC) C09K H01L |

The present search report has been drawn up for all claims

| Place of search | Date of completion of the search | Examiner |
|---|---|---|
| The Hague | 7 January 2019 | Lehnert, Andreas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 3 604 478 A1**

## ANNEX TO THE EUROPEAN SEARCH REPORT
## ON EUROPEAN PATENT APPLICATION NO.

EP 18 38 2592

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2019

| Patent document cited in search report | | Publication date | Patent family member(s) | | Publication date |
|---|---|---|---|---|---|
| US 2007108888 | A1 | 17-05-2007 | TW | I291247 B | 11-12-2007 |
| | | | US | 2007108888 A1 | 17-05-2007 |
| | | | US | 2009280592 A1 | 12-11-2009 |
| US 2010059771 | A1 | 11-03-2010 | CN | 102132373 A | 20-07-2011 |
| | | | JP | 2012502488 A | 26-01-2012 |
| | | | KR | 20110055581 A | 25-05-2011 |
| | | | TW | 201027004 A | 16-07-2010 |
| | | | US | 2010059771 A1 | 11-03-2010 |
| | | | WO | 2010030694 A1 | 18-03-2010 |
| US 2010207139 | A1 | 19-08-2010 | CN | 101238596 A | 06-08-2008 |
| | | | EP | 1913646 A1 | 23-04-2008 |
| | | | JP | 2009504809 A | 05-02-2009 |
| | | | KR | 20080037707 A | 30-04-2008 |
| | | | TW | 200711187 A | 16-03-2007 |
| | | | US | 2010207139 A1 | 19-08-2010 |
| | | | WO | 2007017049 A1 | 15-02-2007 |
| US 2006063155 | A1 | 23-03-2006 | AT | 501230 T | 15-03-2011 |
| | | | AU | 2003292201 A1 | 22-07-2004 |
| | | | DE | 10259935 A1 | 01-07-2004 |
| | | | EP | 1578888 A1 | 28-09-2005 |
| | | | JP | 4652817 B2 | 16-03-2011 |
| | | | JP | 2006514887 A | 18-05-2006 |
| | | | US | 2006063155 A1 | 23-03-2006 |
| | | | WO | 2004058914 A1 | 15-07-2004 |
| US 3999145 | A | 21-12-1976 | NONE | | |
| US 3690929 | A | 12-09-1972 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **Z. XIA ; Q. LIU.** *Progress in Materials Science,* 2016, vol. 84, 59
- **YE S ; XIAO F ; PAN YX ; MA Y Y ; ZHANG Q Y.** *Mater. Sci. Eng. Rep.,* 2010, vol. 71 (1
- **S. MURAI ; M.A. VERSCHUUREN ; G. LOZANO ; G. PIRRUCCIO ; A.F. KOENDERINK ; J. GOMEZ RIVAS.** *Opt. Mater. Ex.,* 2012, vol. 2, 1111
- **S. MURAI ; T. SATO ; S. YAO ; R. KAMAKURA ; K. FUJITA ; K. TANAKA.** *J. Luminescence,* 2016, vol. 170, 808
- **A. SANTANA-ALONSO ; J. MENDEZ-RAMOS ; A.C. YANES ; J. DEL-CASTILLO ; V.D. RODRIGU-EZ.** *Mater. Chem. Phys.,* 2010, vol. 124, 699
- **D. CHEN ; W. XIANGB ; X. LIANG ; J. ZHONG ; H. YU ; M. DING ; H. LU ; Z. JI.** *J. Eur. Ceram. Soc.,* 2015, vol. 35, 859
- **L. LIU ; M. YU ; J. ZHANG ; B. WANG ; W. LIUA ; Y. TANG.** *J. Mater. Chem. C,* 2015, vol. 3, 2326
- **S. ZHOU ; N. JIANG ; B. ZHU ; H. YANG ; S. YE ; G. LAKSHMINARAYANA ; J. HAO ; J. QIU.** *Adv. Funct. Mater.,* 2008, vol. 18, 1407
- **T. SHEN ; Y ZHANG ; W. LIU ; Y. TANG.** *J. Mater. Chem. C,* 2015, vol. 3, 1807
- **K.-H. LEE ; B.-I. LEE, ; J.-H. YOU ; S.-H. BYEON.** *Chem. Commun.,* 2010, vol. 46, 1461
- **L. V. MEYER ; F. SCHÖNFELD ; K.MÜLLER-BUSCHBAUM.** *Chem. Commun.,* 2014, vol. 50, 8093